# EUROPÄISCHE PATENTSCHRIFT

(11) **EP 0 463 356 B1**
(45) Veröffentlichungstag und Bekanntmachung des Hinweises auf die Patenterteilung: **03.09.1997**
(21) Anmeldenummer: 91108080.2
(22) Anmeldetag: 18.05.1991
(51) Int. Cl.: G01D 5/16, H03H 7/24

(54) **Einrichtung zur Verringerung des Rauschens bei einer Potentiometerauswertung**
Device for reducing the noise of a potentiometer position evaluation
Dispositif pour réduire le bruit d'évaluation de la position d'un potentiomètre

(30) Priorität: 23.06.1990 DE 4020105
(43) Veröffentlichungstag der Anmeldung: 02.01.1992
(73) Patentinhaber: ROBERT BOSCH GMBH, 70442 Stuttgart (DE)
(72) Erfinder: Steinruecken, Heinrich, Ing.grad., W-7140 Ludwigsburg (DE); Sauer, Rudolf, Dr. Dipl.-Ing., W-7141 Benningen (DE); Kleinhans, Josef, Dipl.-Ing., W-7143 Vaihingen/Enz (DE); Witzig, Armin, Dipl.-Ing., W-7253 Renningen (DE)
(74) Vertreter: Müller, Georg

(56) Entgegenhaltungen:
- DE-A- 2 927 295
- US-A- 4 280 465
- US-A- 4 920 939
- THE ART OF ELECTRONICS, P. HOROWITZ et al., 1980, pp. 103-105, Cambridge University Press, Cambridge, UK
- INTEGRATED ELECTRONICS : ANALOG AND DIGITAL CIRCUITS AND SYSTEMS, Millman-Halkias, McGraw-Hill, 1972, pp. 504
- CAPTEURS EN INSTRUMENTATION INDUSTRIELLE, G. ASCH et al., Paris, FR, 1982, pp. 316-317

## Beschreibung

Die Erfindung betrifft eine Einrichtung zur Verringerung des Rauschens bei einer Potentiometerauswertung bei einem Drosselklappenpotentiometer oder bei einem Luftmassenmesser-Potentiometer, beispielsweise einer Stauklappe einer Brennkraftmaschine.

Es ist allgemein bekannter Stand der Technik, die Stellung der Drosselklappe, von der die Menge der von der Brennkraftmaschine angesaugten Luft abhängt, mit Hilfe eines Drosselklappenpotentiometers zu bestimmen. Dabei entspricht das Drosselklappenpotentiometer einem mechanisch veränderbaren Widerstand, der als Spannungsteiler geschaltet ist und an dessen Schleiferausgang die Signalspannung abgegriffen wird.

Wegen der geforderten genauen Zuordnung von Spannungswerten und Potentiometerstellung sind für die elektrischen Werte nur verhältnismäßig enge Toleranzen zugelassen. Diese sollen auch nach längerer Betriebsdauer eingehalten werden. Infolge von Alterung, Einwirkung von Kraftstoff, Öl, Kondenswasser usw. kann sich jedoch der Übergangswiderstand am Schleifer so verändern, daß unerwünschte Spannungseinbrüche auftreten und zu einem verrauschten Signal führen.

Damit kann die Zuordnung von Signalspannung und Schleiferstellung verfälscht werden, dies kann zu unerwünschten Fahrzuständen führen.

Aus der US-PS 4 920 939 ist ein Lagesensor bekannt, mit dem beispielsweise die Stellung der Drosselklappe einer Brennkrafmaschine ermittelt werden kann. Dieser Sensor umfaßt ein Potentiometer, dessen Schleifer mit der Drosselklappe in Verbindung steht. Das Potentiometer liegt zwischen einer Versorgungsspannung und Masse, am Schleifer wird ein Schleiferstrom abgegriffen, der ein Maß für die Schleiferstellung und damit die Winkellage der Drosselklappe ist. Zur Überwachung der Funktionsfähigkeit des Lagesensors wird der das Potentiometer durchfließende Strom ausgewertet. Da der Schleiferstrom bezüglich dieses Stromes vernachlässigbar klein ist, kann aus dem durch das Potentiometer fließenden Strom unabhängig von der Schleiferposition eine sichere Fehlererkennung realisiert werden.

Die US-PS 4 280 465 zeigt eine Auswerteschaltung für ein Potentiometer, bei der der Schleiferstrom des Potentiometers in einem nachfolgenden Verstärker verstärkt wird. Ein dazwischen geschaltetes Widerstandsnetzwerk ist so beschaltet, daß eine zuverlässige Auswertung des Schleiferstromes möglicht ist und eine einfache Einstellung des Auswertebereiches möglich ist.

Aus der Druckschrift "The art of electronics, Horowitz et al., Cambridge University Press, Cambridge 1980, EP.103 - 104" sind Beschaltungen und Dimensionierungen für einen Operationsverstärker bekannt. Dabei wird insbesonders bezüglich des Eingangsstromes für einen solchen Operationsverstärker ausgeführt, daß er klein sein soll. Als Beispiel für einen solchen Eingangsstrom wird ein Wert von 80 Picoampere angegeben.

Einsatzmöglichkeiten eines solchen Operationsverstärkers bei der Auswertung des Schleiferstromes eines Potentiometers sind jedoch nicht angegeben.

Die erfindungsgemäße Einrichtung mit den Merkmalen des Anspruchs 1 hat den Vorteil, daß Spannungseinbrüche weitestgehend verhindert werden. Erzielt wird dieser Vorteil, indem bei einem Drosselklappen-potentiometer oder einem Luftmassenmesser-Potentiometer bei einer Brennkraftmaschine, das zwischen einer Referenzspannung und Masse geschaltet ist, der am Schleiferausgang des Potentiometers abreifbare Potentiometerstrom durch eine geeignete Beschaltung soweit verringert wird, daß er stets kleiner als ein Mikroampere ist. In einer nachfolgenden Verstärkeranordnung wird der Schleiferstrom so verstärkt, daß dem sich anschließenden Steuergerät ein Strom von wenigstens 40 Mikroampere zugeführt wird. Das Potentiometer ist von einer Potentiometerkammer umgeben und die Verstärkungsanordnung befindet sich innerhalb der Potentiometerkammer oder auf einem Zwischenstecker, der über geeignete Steckverbindungen an der Potentiometerkammer befestigt ist. Durch eine Filterung des Potentiometer-Ausgangssignals mittels eines Filters, das dem Potentiometer nachgeschaltet ist, wird eine Signalglättung erzielt.

Vorteilhafte Weiterbildungen und Verbesserungen der erfindungsgemäßen Einrichtung sind in den Unteransprüchen angegeben.

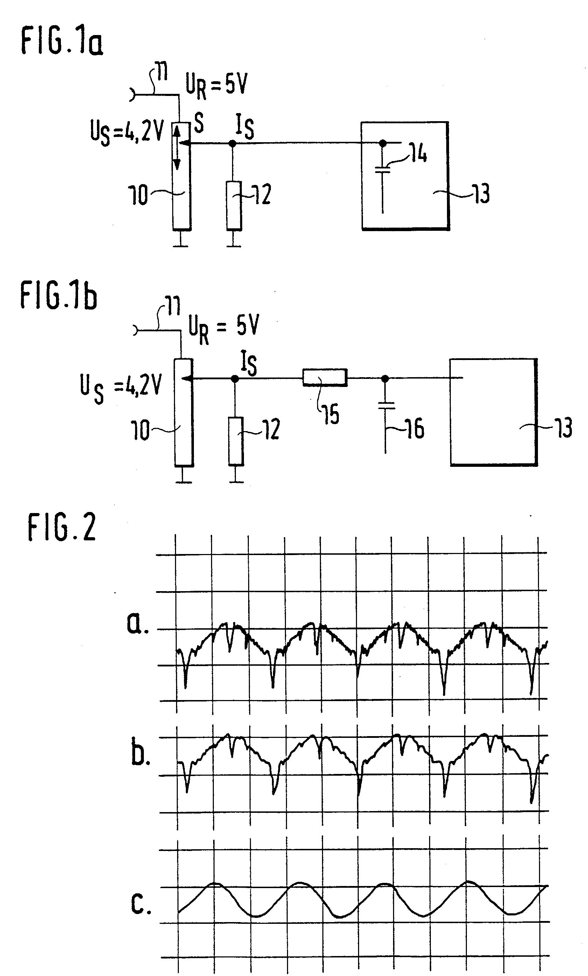

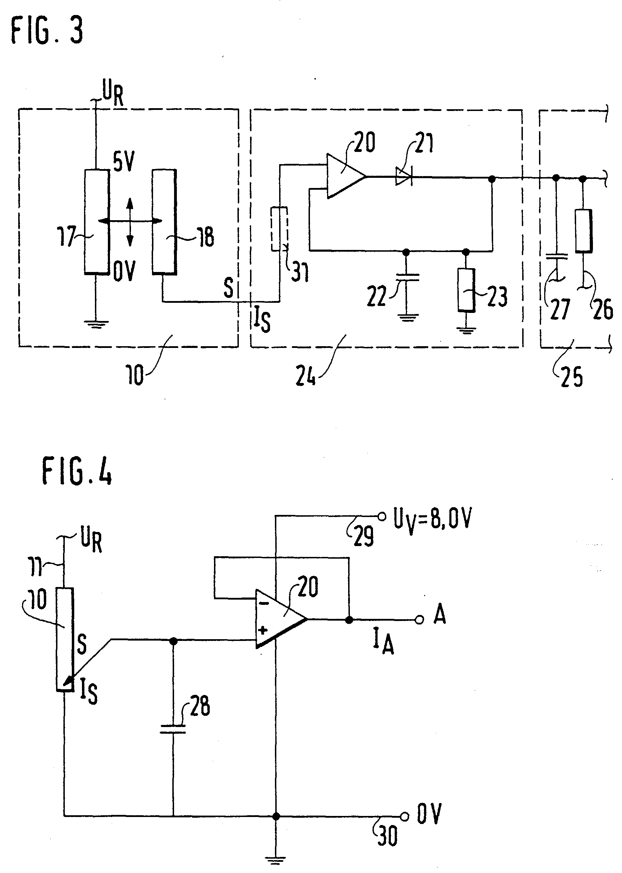

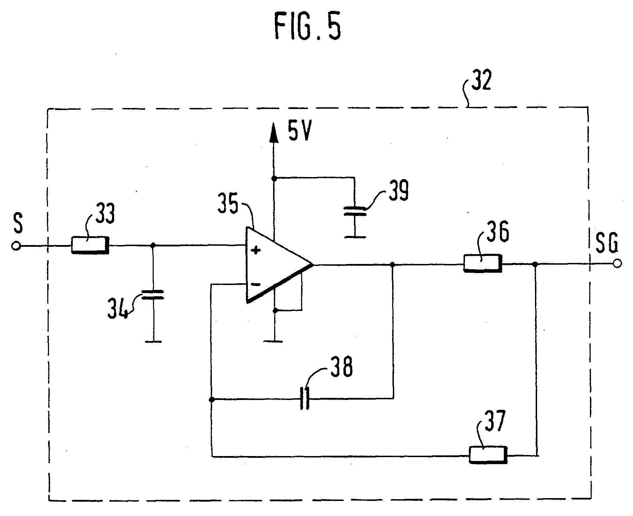

Figur 1a bzw. Figur 1b zeigen eine Testschaltung ohne bzw. mit zusätzlichem Filter, mit der Zitterversuche durchgeführt wurden. Die Figuren 2a bis 2c zeigen den Verlauf des Schleiferstroms für drei unterschiedliche Bedingungen, Figur 3 zeigt eine erstes Ausführungsbeispiel einer Potentiometer-Auswerteschaltung und Figuren 4 und 5 stellen weitere Ausführungsbeispiele dar.

In einer Anordnung nach Figur la ist ein Potentiometer 10, beispielsweise ein Drosselklappen-Potentiometer oder ein Luftmengenmesser-Potentiometer zwischen eine Klemme 11, an der die Referenzspannung U_{R} anliegt und Masse geschaltet. Das Potentiometer 10 weist einen Schleiferausgang S auf, der über einen Widerstand 12 mit Masse verbunden ist und außerdem direkt mit einem Oszillographen 13 verbunden ist. Der Oszillograph selbst weist u.a. einen Eingangskondensator 14 auf, der zusammen mit dem Widerstand 11 als Filter mit einer Zeitkonstanten von: τ = 2 Mikrosekunden wirkt (τ = 2 µs).

Die Schleiferstellung des Potentiometers wird so gewählt, daß am Schleiferausgang S eine Spannung von U_{S} = 4,2 V liegt. Zur Veränderung des am Schleiferausgang S entnommenen Schleiferstromes I_{S} werden nacheinander drei verschiedene Widerstandswerte des Widerstandes 12 ausgewählt, nämlich 52 kΩ, 500 kΩ und 5,1 MΩ, so daß sich Schleiferströme I_{S} von 80 Mikroampere (80 µA), 8,4 Mikroampere und 0,82 Mikroampere ergeben.

In Figur 1b ist die aus Figur la bekannte Anordnung um einen Widerstand 15 und einen Kondensator 16, die ein gemeinsam ein Filter mit einer Zeitkonstanten von τ = 220 Mikrosekunden bilden, erweitert.

Die Spannung zwischen Klemme 11 und Masse beträgt ebenfalls 5 Volt und die Schleiferspannung 4,2 Volt. Die Größe des Widerstandes 12 ist wiederum so wählbar, daß Schleiferströme I_{S} derselben Größe wie bei Figur 1a auftreten.

Werden mit den aus Figur 1a und Figur 1b bekannten Anordnungen Zitterversuche durchgeführt, ergeben sich Schleiferströme I_{S}, deren Verläufe in den Figuren 2a, b, c dargestellt werden.

Bei solchen Zitterversuchen wird der Schleifer in der in Figur 1a durch den Doppelpfeil angedeuteten Richtung hin und her bewegt, so daß eine den realen Verhältnissen im Kraftfahrzeug nachgebildete Bewegung entsteht. Als Parameter für die Zitterversuche werden ausgewählt:
Frequenz der Zitterbewegung: 40-50 Hz
Winkel der Zitterbewegung: 2°
Kontaktdruck 12
Versorgungsspannung U_{R} = 5 V

Infolge der Zitterbewegungen verändert sich die Schleiferspannung etwa zwischen 4,1 V und 4,3 V bei einer eingestellten Schleiferspannung von 4,2 V und führt daher zu einer sinusförmigen Schwankung des Schleifenstromes I_{S}.

In Figur 2a ist der Verlauf des Schleiferstroms I_{S}, der in einem nachgeschalteten Oszillographen zu einer entsprechenden Spannung führt, für einen Schleiferstrom von etwa 80 Mikroampere und eine Zitterbewegung mit 50 Hertz dargestellt. Jeweils bei den Maxima bzw. Minima der Zitterbewegung treten zuerst Spannungseinbrüche auf, die von dem in diesen Punkten abgelagerten Schleiferabrieb verursacht werden und beim gewählten Schaltungsbeispiel 0,3 Volt betragen. Die im Oszillographen gemessenen Spannungsschwankungen betragen insgesamt jedoch 0,2 bis 0,3 Volt. Der Signalverlauf nach Figur 2a wurde mit einer Anordnung gemäß Figur 1 und einem Lastwiderstand 11 von 52 kΩ erhalten.

Mit den gleichen Bedingungen, jedoch einem zusätzlichen Filter nach Figur 1b wird ein Signalverlauf entsprechend Figur 2b erhalten. Dabei ist das Signal insgesamt geglättet, die Spannungseinbrüche in den Minima bzw. Maxima treten jedoch weiterhin auf.

Wird der Widerstand 11 weiter vergrößert, d.h. wird der Schleiferstrom I_{S} weiter verringert, nehmen die Spannungsabbrüche leicht ab, sie sind jedoch weiterhin nicht zu vernachlässigen.

Erst bei einer Verringerung des Schleiferstroms auf 0,82 Mikroampere, was einem Widerstand 11 von 5,1 MΩ entspricht, wird ein Signalverlauf erhalten, der keine Spannungseinbrüche mehr aufweist. Figur 2c zeigt dies für eine Anordnung nach Figur 1a ohne zusätzliche Filter, mit einer Anordnung nach Figur 1b kann noch eine weitere Glättung erhalten werden.

Da die Verringerung des Schleiferstroms I_{S} auf Werte von weniger als einem Mirkoampere keine Strom- bzw. Spannungseinbrüche aufweist, muß dafür gesorgt werden, daß der am Schleiferausgang S abgegriffene Schleiferstrom I_{S} auf derart kleine Werte beschränkt bleibt. Für die nachfolgende Auswertung in einem Steuergerät sind jedoch Ströme von einigen zig-Mikroampere, beispielsweise 40 Mikroampere erforderlich, daher muß der Schleiferstrom I_{S} mit einer Verstärkeranordnung auf die erforderliche Größe verstärkt werden.

In Figur 3 ist eine erste Anordnung dargestellt, mit der der am Potentiometer abgegriffene Schleiferstrom I_{S} vor der Zuführung in ein Steuergerät verstärkt wird.

Das Bezugszeichen 10 stellt ein Potentiometer dar, das zwischen der Referenzspannung U_{R} und Masse liegt. Dabei besteht das Potentiometer aus einer Potentiometerbahn 17 und einer Kollektorbahn 18. Der Schleifer 19 bewegt sich auf der Potentiometerbahn 17 und der Kollektorbahn 18 synchron hin und her. Entspricht das Potentiometer 10 einem Drosselklappenpotentiometer, dann wäre in der Anordnung nach Figur 3 eine Schleiferverstellung nahe dem Referenzspannungseingang mit einer völlig geöffneten Drosselklappe gleichzusetzen, während die entgegengesetzte Stellung einer völlig geschlossenen Drosselklappe entsprechen würde.

Der Ausgang S des Potentiometers, an dem der Strom I_{S} auftritt, ist mit einem Eingang eines Operationsverstärkers 20 verbunden. Ein weiterer Eingang des Operationsverstärkers 20 ist über eine Diode 21 mit dem Ausgang des Operationsverstärkers 20 verbunden, wobei zwischen dieser Verbindung und Masse ein Kondensator 22 und ein Widerstand 23 liegt. Die Versorgung des Operationsverstärkers 20 erfolgt über einen weiteren Eingang, der an eine Versorgungsspannung U_{R} angeschlossen ist.

Über die Kathode der Diode 21 ist die Verstärkeranordnung 24 mit einem Steuergerät 25 verbunden, wobei am Eingang des Steuergeräts 25 ein R-C-Filter 26, 27 liegt.

Der am Schleiferausgang S abgegriffene Schleiferstrom I_{S}, der abhängig ist von der Schleiferstellung wird in der Verstärkeranordnung 24 so verstärkt, daß dem Steuergerät 25 ein Strom von wenigstens 40 Mikroampere zugeführt wird. Durch geeignete Dimensionierung der Schaltung muß dafür gesorgt werden, daß der Schleiferstrom I_{S} für jede Schleiferstellung kleiner als ein Mikroampere bleibt, gegebenenfalls ist ein zusätzlicher Widerstand 31 einzufügen, der den Stromfluß I_{S} beschränkt, so daß I_{S} immer kleiner als 1 µA bleibt. Wenn der am Schleiferausgang S abgegriffene Strom kleiner als ein Mikroampere bleibt, ist sichergestellt, daß Strom- bzw. Spannungseinbrüche nur selten auftreten. Gleichzeitig wird sichergestellt, daß dem Steuergerät ein Strom zugeführt wird, der so groß ist, daß eine Diagnose, also eine Erkennung, ob eine Fehlfunktion des Potentiometer oder eine Unterbrechung der Signalleitung vorliegt, möglich ist und eine sichere Signalübertragung jederzeit gewährleistet ist.

Die drei Bauelemente 21, 22, 23, die dem Operationsverstärker 20 zugeordnet werden, bewirken einerseits eine Stromverstärkung und bilden andererseits eine Filteranordnung, deren Zeitkonstante davon abhängt, ob eine Spannungsänderung von niedrigeren zu höheren Werten auftritt oder von höheren zu niedrigeren Werten.

Eine solche unterschiedliche Zeitkonstante ist besonders bei der Auswertung von Drosselklappenpotentiometern wünschenswert, da die Schließgeschwindigkeit der Drosselklappe üblicherweise langsamer ist als die Öffnungsgeschwindigkeit, die im Bedarfsfall, also bei einer plötzlichen Beschleunigung etwa 50 Millisekunden beträgt, wobei die Drosselklapope in diesen 50 Millisekunden von der Leerlaufstellung in die Vollaststellung wechselt.

Damit eventuell auftretende Einbrüche des Schleiferstromes I_{S}, die eine Dauer von ca. 1 µs aufweisen, zuverlässig herausgefiltert werden können, darf die Filter-Zeitkonstante τ üblicherweise nur 1 bis 2 Millisekunden betragen, während der Schließbewegung wären dagegen höhere Filter-Zeitkonstanten τ von mehr als 10 Millisekunden akzeptabel.

Durch die Diode 21 wird gerade eine solche höhere Filter-Zeitkonstante τ während der Schließbewegung der Drosselklappe, also während der Phase der Verringerung der Schleifspannung U_{S} erreicht, wodurch Störungen sicher herausgefiltert werden.

In Figur 4 ist ein weiteres Ausführungsbeispiel dargestellt. Dabei ist ein Potentiometer 10 über eine Klemme 11 an die Referenzspannung U_{R} angeschlossen, während der andere Ausgang des Potentiometers auf Masse liegt. Der Schleiferausgang S ist mit dem nichtinvertierenden Eingang eines Operationsverstärkers 20 verbunden, der invertierende Eingang des Operationsverstärkers 20 ist direkt mit seinem Ausgang verbunden. Zwischen dem nichtinvertierenden Eingang des Operationsverstärkers 20 und Masse liegt ein Kondensator 28.

Der Operationsverstärker 20 ist weiterhin an eine Klemme 29, an der die Versorgungsspannung U_{V} anliegt und an eine Masseklemme 30 angeschlossen.

Am Schleiferausgang S wird der Schleiferstrom I_{S} abgegriffen, der im Operationsverstärker 20 verstärkt wird, so daß am Ausgang A des Operationsverstärkers 20 ein Strom I_{A} auftritt. Üblicherweise ist der Ausgang A des Operationsverstärkers mit einem Steuergerät 25, in dem die Auswertung des Potentiometerstromes erfolgt, verbunden. Die Versorgungsspannung U_{V} entspricht entweder der Referenzspannung U_{R}, sie kann jedoch auch einige Volt höher liegen.

Der Kondensator 28 wird eingesetzt, um kurzfristige Einbrüche des Schleiferstroms I_{S} zu kompensieren. Da er auf der Eingangsseite des Operationsverstärkers 20 liegt, kann er sehr klein dimensioniert sein, ein Wert von 10 Nanofarad ist ausreichend.

Im Operationsverstärker 20 wird der Schleiferstrom I_{S} so verstärkt, beispielsweise auf 40 µA, so daß im Steuergerät eine problemlose Weiterverarbeitung erfolgen kann, obwohl der Schleiferstrom selbst weniger als 1 µA beträgt.

Ein weiteres Ausführungsbeispiel ist in Figur 5 dargestellt. Zwischen dem Schleiferausgang S und dem Steuergerät 25 ist wiederum eine Verstärkungsanordnung 32 angeordnet, deren Aufbau sich von der Verstärkungsanordnung 24 nach Figur 3 etwas unterscheidet. Am Eingang der Verstärkerschaltung 32 liegt ein Tiefpaß, der aus dem Widerstand 33 und dem gegen Masse geschalteten Kondensator 34 besteht.

An den Tiefpaß schließt sich ein Operationsverstärker 35 mit den Ein- /Ausgängen 2, 3, 4, 5, 6, 7 an, wobei der Ausgang 6 über einen weiteren Widerstand 36 mit dem Steuergerät 25 verbunden ist. Zwischen dem invertierenden Eingang 2 des Operationsverstärkers 35 und dem Steuergerät 25 liegt ein weiterer Widerstand 37 und zwischen dem Eingang 2 und dem Ausgang 6 ist ein weiterer Kondensator 38 angeordnet.

Die Eingänge 4 und 5 liegen auf Masse und Eingang 7 liegt an der 5V Versorgungsspannung, wobei zusätzlich noch ein Kondensator 39 zwischen der Versorgungsspannung und Masse angeordnet ist.

Das Potentiometersignal, bzw. der Potentiometerstrom, der am Schleifer S abgenommen wird und über die Verstärkungsanordnung 32 dem Steuergerät zugeführt wird, kann infolge der Verstärkung in 32 so klein gehalten werden, daß keine Spannungseinbrüche auftreten.

Die Verstärkungsanordnung 20, 24 bzw. 32 kann entweder in räumlicher Nähe vom Potentiometer angeordnet werden, bei einen Luftmassenmesser beispielsweise innerhalb der Potentiometerkammer, sie kann jedoch auch in der Nähe oder auch innerhalb des Steuergerätes 25 angeordnet werden.

In besonders vorteilhafter Weise wird die Verstärkungsanordnung 24, 32 auf einem Zwischenstecker angeordnet. Dieser Zwischenstecker wird dann in geeigneter Weise an einer Potentiometerkammer bzw. am Potentiometergehäuse befestigt werden. Der Zwischenstecker kann daher so ausgestaltet sein, wie es aus der DE-OS 29 27 295 bekannt ist, die Befestigung kann in ähnlicher Weise wie beim Gegenstand der DE-OS 29 27 295 erfolgen, wobei passende Steckverbindungen auf dem Potentiometer und dem Stecker erforderlich sind.

Bei Verwendung eines Keramikpotentiometers können die für die Verstärkung benötigten Bauelemente direkt auf dem Keramiksubstrat als Hybridschaltung angebracht werden.

## Patentansprüche

1. Einrichtung zur Rauschspitzenunterdrückung bei einer Potentiometerauswertung, bei der das Potentiometer, das ein Drosselklappenpotentiometer oder ein Luftmassenmesser-Potentiometer bei einer Brennkraftmaschine ist, zwischen eine Referenzspannung und Masse geschaltet ist und der am Schleiferausgang des Potentiometers abgegriffene Schleiferstrom über einen Signalpfad, der wenigstens eine Verstärkungsanordnung mit einem Operationsverstärker umfaßt, die zwischen dem Potentiometer und einem Steuergerät liegt, dem Steuergerät zugeführt wird, dadurch gekennzeichnet, daß das Potentiometer von einer Potentiometerkammer umgeben ist und sich die Verstärkungsanordnung innerhalb der Potentiometerkammer befindet oder auf einem Zwischenstecker angeordnet ist, der über geeignete Steck verbindungen an der Potentiometerkammer befestigt ist und daß die Einrichtung so dimensioniert wird, daß der Schleiferstrom stets kleiner als ein Mikroampere ist und in der Verstärkungsanordnung eine Verstärkung des Schleiferstromes derart erfolgt, daß dem Steuergerät ein Strom von wenigstens 40 Mikroampere zugeführt wird, und daß zusätzlich eine Filteranordnung mit dem Signalpfad in Verbindung steht.

2. Einrichtung nach Anspruch 1, dadurch gekennzeichnet, daß im Rückkopplungszweig des Operationsverstärkers (20) eine Diode (21) liegt.

3. Einrichtung nach Anspruch 2, dadurch gekennzeichnet, daß die Anode der Diode (21) mit dem Ausgang des Operationsverstärkers (20) und die Kathode der Diode (21) mit einem der Eingänge des Operationsverstärkers (20) und mit dem Steuergerät (25) verbunden ist, wobei der andere Eingang des Operationsverstärkers (20) mit dem Potentiometer (10) verbunden ist.

4. Einrichtung nach Anspruch 2 oder 3, dadurch gekennzeichnet, daß im Rückkopplungszweig der Verstärkungsanordnung (24) ein R-C-Filter (22, 23) liegt.

5. Einrichtung nach einem der vorhergehenden Ansprüche, dadurch gekennzeichnet, daß der Schleiferausgang (S) des Potentiometers (10) mit dem nichtinvertierenden Eingang des Operationsverstärkers (20) verbunden ist und zwischen dem nichtinvertierenden Eingang des Operationsverstärkers und Masse ein Glättungskondensator (28) liegt.

6. Einrichtung nach einem der vorhergehenden Ansprüche 1 bis 5, dadurch gekennzeichnet, daß das Potentiometer (10) ein Keramikpotentiometer ist und die Verstärkungsanordnung (24) als Hybridschaltung auf dem Keramiksubstrat angebracht ist.

## Claims

1. Device for suppressing noise peaks in a potentiometer evaluation, in which device the potentiometer, which is a throttle valve potentiometer or an air flow rate meter potentiometer in an internal combustion engine, is connected between a reference voltage and earth, and the wiper current tapped at the wiper output of the potentiometer is fed to the control unit via a signal path which comprises at least one amplification arrangement with an operational amplifier which is located between the potentiometer and a control unit, characterized in that the potentiometer is surrounded by a potentiometer chamber and the amplification arrangement is located within the potentiometer chamber or is arranged on an intermediate plug which is attached to the potentiometer chamber via suitable plug-type connections, and in that the device is dimensioned in such a way that the wiper current is always lower than a microampere and amplification of the wiper current takes place in the amplification arrangement in such a way that a current of at least 40 microamperes is fed to the control unit, and in that, in addition, a filter arrangement is connected to the signal path.

2. Device according to Claim 1, characterized in that a diode (21) is located in the feedback branch of the operational amplifier (20).

3. Device according to Claim 2, characterized in that the anode of the diode (21) is connected to the output of the operational amplifier (20) and the cathode of the diode (21) is connected to one of the inputs of the operational amplifier (20) and to the control unit (25), the other input of the operational amplifier (20) being connected to the potentiometer (10).

4. Device according to Claim 2 or 3, characterized in that an RC filter (22, 23) is located in the feedback branch of the amplification arrangement (24).

5. Device according to one of the preceding claims, characterized in that the wiper output (S) of the potentiometer (10) is connected to the non-inverting input of the operational amplifier (20) and a smoothing capacitor (28) is located between the non-inverting input of the operational amplifier and earth.

6. Device according to one of the preceding Claims 1 to 5, characterized in that the potentiometer (10) is a ceramic potentiometer and the amplification arrangement (24) is provided as a hybrid circuit on the ceramic substrate.

## Revendications

1. Dispositif servant à supprimer les pointes de bruit dans le cas d'une exploitation d'un potentiomètre, lors de laquelle le potentiomètre qui est un potentiomètre de clapet d'étranglement ou un potentiomètre d'appareil de mesure d'une masse d'air dans un moteur à combustion interne, est branché entre une tension de référence et la masse et l'intensité du curseur prélevée à la sortie du curseur du potentiomètre est amenée par un trajet de signal, qui comprend au moins un dispositif d'amplification avec un amplificateur d'opération qui se trouve entre le potentiomètre et un appareil de commande, à l'appareil de commande,
caractérisé en ce que
le potentiomètre est entouré par une chambre de potentiomètre et que le dispositif d'amplification se trouve à l'intérieur de la chambre du potentiomètre ou est disposé sur un connecteur intermédiaire, qui est fixé par des connexions appropriées sur la chambre du potentiomètre et en ce que le dispositif est dimensionné de telle façon que l'intensité du curseur est en permanence inférieure à un microampère et en ce que dans le dispositif d'amplification il se produit une amplification de l'intensité du curseur telle que l'on amène à l'appareil de commande une intensité d'au moins 40 microampère et en ce qu'en plus un dispositif d'amplification est en liaison avec le trajet des signaux.

2. Dispositif selon la revendication 1,
caractérisé en ce qu'
une diode (21) se trouve dans la branche de rétroaction de l'amplificateur opérationnel (20).

3. Dispositif selon la revendication 2,
caractérisé en ce que
l'anode de la diode (21) est reliée à la sortie de l'amplificateur opérationnel (20) et la cathode de la diode (21) est reliée à l'une des entrées de l'amplificateur opérationnel (20) et à l'appareil de commande (25), l'autre entrée de l'amplificateur opérationnel (20) étant reliée au potentiomètre (10).

4. Dispositif selon la revendication 2 ou 3,
caractérisé en ce que
dans la branche de rétroaction du dispositif d'amplification (24) il y a un filtre R-C (22, 23).

5. Dispositif selon l'une des revendications précédentes,
caractérisé en ce que
la sortie du curseur (S) du potentiomètre (10) est reliée à l'entrée non inversante de l'amplificateur opérationnel (20) et en ce qu'entre l'entrée non inversante de l'amplificateur opérationnel et la masse il y a un condensateur de lissage (28).

6. Dispositif selon l'une des revendications précédentes 1 à 5,
caractérisé en ce que
le potentiomètre (10) est un potentiomètre céramique et en ce que le dispositif d'amplification (24) est mis, en tant que circuit hybride, sur le substrat céramique.
